(19) Europäisches Patentamt

European Patent Office

Office européen des brevets

(11) **EP 1 686 590 A2**

(12) **EUROPÄISCHE PATENTANMELDUNG**

(43) Veröffentlichungstag:
   **02.08.2006 Patentblatt 2006/31**

(51) Int Cl.:
   ***G11C 16/02*** *(2006.01)*

(21) Anmeldenummer: **06000913.1**

(22) Anmeldetag: **17.01.2006**

(84) Benannte Vertragsstaaten:
   **AT BE BG CH CY CZ DE DK EE ES FI FR GB GR HU IE IS IT LI LT LU LV MC NL PL PT RO SE SI SK TR**
   Benannte Erstreckungsstaaten:
   **AL BA HR MK YU**

(30) Priorität: **28.01.2005 DE 102005004107**

(71) Anmelder: **Infineon Technologies AG**
   **81669 München (DE)**

(72) Erfinder: **Liaw, Corvin**
   **81737 München (DE)**

(74) Vertreter: **Epping, Wilhelm**
   **Epping Hermann Fischer**
   **Patentanwaltsgesellschaft mbH**
   **Ridlerstrasse 55**
   **80339 München (DE)**

(54) **Integrierter Halbleiterspeicher mit einer Anordnung nichtflüchtiger Speicherzellen und Verfahren**

(57)   Bei integrierten Halbleiterspeichern, deren gespeicherte Informationen durch die Größe des ohmschen Widerstandes von Schichtenstapeln mit jeweils einer Schicht aus einem Festkörperelektrolyten dargestellt werden, tritt das Problem auf, das wegen der von Speicherzelle zu Speicherzelle unterschiedlich großen Schwellwerte (G1, G2) für die Schreibspannung und die Löschspannung die Speicherzellen zwar einzeln programmierbar sind, jedoch herkömmlich nicht einzeln, d. h. selektiv zu den übrigen Speicherzellen gelöscht werden können. Grund dafür ist die große, von einem Potential (Verasemin) bis zu einem Potential (Verasemax) reichende Bandbreite der Schwellwerte (G1) für die Löschspannungen. Erfindungsgemäss wird ein Halbleiterspeicher und ein Verfahren zu des Betreiben vorgeschlagen, bei denen durch ein gleichzeitiges Vorspannen sämtlicher Bitleitungen und Wortleitungen und durch eine gezielte Wahl der elektrischen Potentiale eine einzelne Speicherzelle selektiv zu den übrigen Speicherzellen gelöscht werden kann.

FIG 3

**Beschreibung**

Die Erfindung betrifft einen integrierten Halbleiterspeicher mit einer Anordnung nichtflüchtiger Speicherzellen. Die Erfindung betrifft ferner ein Verfahren zum Betreiben eines solchen Halbleiterspeichers.

Integrierte Halbleiterspeicher lassen sich nach der Speicherdauer gespeicherter Informationen klassifizieren. Flüchtige Halbleiterspeicher wie beispielsweise DRAMs (Dynamic Random Access Memories) besitzen Speicherzellen, die die eingeschriebenen Informationen nur für Bruchteile von Sekunden speichern und daher stets erneut wiederaufgefrischt werden müssen. In nichtflüchtigen Halbleiterspeichern hingegen bleiben gespeicherte Informationen auch nach Abschalten der Stromversorgung über einen langen Zeitraum, typischerweise mehrere Jahre erhalten.

Eine besonders platzsparende Anordnung von Speicherzellen wird bei solchen Halbleiterspeichern erzielt, deren Speicherzellen an Kreuzungsorten von Bitleitungen und Wortleitungen Schichtenstapel aufweisen, die keinerlei Auswahltransistor erfordern. Bei solchen als "cross-point-arrays" bezeichneten Speichertypen ergibt sich die pro Speicherzelle erforderliche Substratfläche aus dem Rastermaß der Bitleitungen und der Wortleitungen.

In dieser Bauweise können beispielsweise Halbleiterspeicher hergestellt werden, deren Speichermedium ein Festkörperelektrolyten ist. Ein Schichtenstapel, der sowohl eine Schicht aus dem Festkörperelektrolyten als auch die metallhaltige Schicht aufweist, ist an entgegengesetzten Seiten an Leiterbahnen angeschlossen. Über die Leiterbahnen, die beispielsweise als Bitleitungen und Wortleitungen bezeichnet werden können, lassen sich elektrische Spannungen anlegen. Der Schichtenstapel, der zwischen je einer Bitleitung und einer Wortleitung angeordnet ist, wird bei Anlegen der Spannung zwischen der Bitleitung und der Wortleitung von einem Strom durchflossen. Die Größe dieses Stroms ist abhängig von dem ohmschen Widerstand des Schichtenstapels.

Auf der einen Seite einer aus einem Festkörperelektrolyten gebildeten Schicht besitzt der Schichtenstapel eine metallhaltige Schicht. Je nach Stromrichtung und Stärke der angelegten Spannung diffundieren Metallionen, die aus der metallhaltigen Schicht stammen, entweder in die Schicht aus dem Festkörperelektrolyten hinein oder aus diesem heraus zurück in die metallhaltige Schicht. Wenn die in die Schicht aus dem Festkörperelektrolyten eindiffundierten Metallionen bis zu der der metallhaltigen Schicht abgewandten Grenzfläche der festkörperelektrolytischen Schicht diffundiert sind, verringert sich der ohmsche Widerstand des Schichtenstapels insgesamt; die nichtflüchtige Speicherzelle ist niederohmig geschaltet, was beispielsweise einem programmierten Speicherzustand entspricht. Bei Anlegen einer ausreichend hohen Spannung entgegengesetzter Polarität hingegen diffundieren die Metallionen wieder aus dem Festkörperelektrolyten hinaus, d.h. zurück in die metallhaltige Schicht. Dadurch wird ein hochohmiger Zustand der Speicherzelle wiederhergestellt. Dieser hochohmige Zustand der Speicherzelle entspricht beispielsweise einem unprogrammierten Speicherzustand.

Nichtflüchtige Halbleiterspeicher der oben beschriebenen Bauweise sind unter dem Namen PMC (Programmable Metallization Cell) oder auch CBRAM (Conductive Bridging Random Access Memory) bekannt. Speicherzellen dieses Typs sind resistiv, d. h. widerstandsabhängig schaltende Elemente. Die Größe des ohmschen Widerstands des Schichtenstapels jeder einzelnen Zelle stellt eine Speicherinformation dar, die je nachdem, ob der Schichtenstapel jeweils hochohmig oder niederohmig ist, eine digitalen "0" oder "1" bedeuten. Physikalisch ergibt sich die gespeicherte Information aus der Verteilung der eindiffundierten Metallionen innerhalb des Festkörperelektrolyten. Diese Verteilung und der sich daraus ergebende Speicherzustand (hochohmig oder niederohmig) ist durch Anlegen einer Messspannung zwischen der Bitleitung und der Wortleitung, an die die Speicherzelle angeschlossen ist, auslesbar.

festkörperelektrolytische Speicherzellen besitzen keine präzisen, für alle Speicherzellen derselben Speicherschaltung identischen Grenzwerte für diejenigen Schwellenspannungen, bei denen der Übergang von dem hochohmigen Zustand in den niederohmigen Zustand oder umgekehrt erfolgt. Beispielsweise variiert innerhalb derselben Speicherschaltung von Zelle zu Zelle der Mindestwert für die Löschspannungen, bei der eine ursprünglich niederohmige Speicherzelle hochohmig wird. Ebenso variiert von Zelle zu Zelle der Mindestwert für die Schreibspannung (negativen Vorzeichens), oberhalb derer eine ursprünglich hochohmige Speicherzelle niederohmig wird. Anstelle diskreter Schwellenspannungen existieren in heutigen festkörperelektrolytischen Halbleiterspeichern somit Schwellenspannungsbereiche vergleichsweise großer Bandbreite bezüglich der anzulegenden Spannungen, die für ein Umprogrammieren der Speicherzellen erforderlich sind. Die Bandbreiten der Schwellenspannungen sind auch im Vergleich zum Mittelwert der jeweiligen Schwellenspannung nicht unerheblich. Häufig ist die Bandbreite der Löschspannungen (d. h. die Verteilung der speicherzellenspezifischen Werte der Mindestlöschspannung) über die angelegte Spannung größer als die Bandbreite der Schreibspannungen, d. h. der Programmierspannungen. Insbesondere ist auch die kleinstmögliche Löschspannung, bei der zumindest einige Speicherzellen, sofern mit dieser Spannung vorgespannt, hochohmig werden, kleiner als der Betrag derjenigen Schreibspannung, bei der zumindest eine der Speicherzellen, sofern mit dieser Schreibspannung vorgespannt, niederohmig werden.

Die Schwellenspannungen für beide Umprogrammiervorgänge, nämlich die Löschspannungen und die Schreibspannungen, sind somit betragsmäßig nicht gleich. Auch die statistische Verteilung der Höhe der Löschspannungen und der Höhe der Schreibspannungen sind nicht symmetrisch zueinander bezüglich einer Vorzeichenumkehr der angelegten Spannung. Führt beispielsweise eine negative Spannung eines bestimmten Absolutbetrags bereits zuverlässig zum Programmieren, d. h. Beschreiben einer Speicherzelle, und zwar unabhängig davon, welche individuelle Speicherzelle damit vorgespannt wird, so braucht eine (positive) Löschspannung gleichen Absolutbetrags noch nicht zwangsläufig zu einem Löschvorgang der mit ihr vorgespannten Speicherzelle zu führen. Denn aufgrund der breiteren Verteilung der Löschspannungen gegenüber den Schreibspannungen existieren in der Speicherschaltung Speicherzellen, die erst bei noch größeren Löschspannungen hochohmig werden.

Da in einem Halbleiterspeicher der Speicherzustand, d. h. die Höhe des ohmschen Widerstands der jeweiligen Speicherzelle eindeutig festgelegt sein muss, müssen die für einen Schreiboder Löschvorgang angelegten Spannungen außerhalb der Bandbreiten der Schreibspannungen und der Löschspannungen liegen.

Eine Spannung für einen Umprogrammiervorgang wird zwischen der Bitleitung und der Wortleitung angelegt. Da jedoch bei einem als Cross-Point-Array ausgebildeten festkörperelektrolytischen Halbleiterspeicher an jede Bitleitung und jede Wortleitung eine Vielzahl von Speicherzellen angeschlossen ist, jedoch keine Auswahltransistoren vorhanden sind, würden beim Anlegen der jeweiligen Programmierspannung ausschließlich über die Bitleitung oder ausschließlich über die Wortleitung jeweils alle Speicherzellen, die an die jeweilige Leitung angeschlossen sind, umprogrammiert. Aus diesem Grund wird zum Einschreiben einer Information in eine Speicherzelle die erforderliche Schreibspannung in Form zweier Teilspannungen, die zusammen die erforderliche Schreibspannung ergeben, an die Bitleitung und an die Wortleitung angelegt. Beispielsweise wird das Potential der Bitleitung, an die die Speicherzelle angeschlossen ist, um einen bestimmten Betrag erhöht und zugleich das Potential der Wortleitung, an die die Speicherzelle angeschlossen ist, um einen bestimmten Betrag abgesenkt.

Da jedoch in einem Cross-Point-Array keine Auswahltransistoren vorhanden sind, liegen die Teilspannungen gleichzeitig auch an denjenigen Schichtenstapeln an, die an dieselbe Bitleitung, jedoch eine andere Wortleitung oder an dieselbe Wortleitung, aber eine andere Bitleitung angeschlossen sind. Diese Teilspannungen können, sofern sie innerhalb der Bandbreite der Löschspannungen oder der Bandbreite der Schreibspannungen liegen oder vom Betrag her noch größer sind, zu einem versehentlichen Umprogrammieren weiterer Speicherzellen führen.

Zumindest für einen Programmier-, d. h. einen Schreibvorgang können diese Teilspannungen unterhalb dieser unteren Bandbreitengrenzen gewählt werden, so dass ausschliesslich die im Kreuzungspunkt der ausgewählten Bitleitung und der ausgewählten Wortleitung liegende Speicherzelle programmiert wird. Dies ist deshalb möglich, weil bei festkörperelektrolytischen Speicherschaltungen die Bandbreite der Schreibspannungen so klein ist, dass eine Spannung, die halb so gross ist wie eine zum zuverlässigen Programmieren ausreichend hohe Schreibspannung, betragsmässig so klein ist, dass sie ausserhalb der Bandbreite der Schwellspannungen für den Programmiervorgang liegt.

Für den umgekehrten Umprogrammiervorgang, nämlich das Löschen ist wegen der noch größeren Bandbreite der Löschspannungen in festkörperelektrolytischen Halbleiterspeichern ein selektiver Zugriff auf einzelne Speicherzellen nicht bekannt. Statt dessen müssten ganze Zeilen, Spalten oder Blöcke von Speicherzellen, die durch jeweils dieselbe Gruppe von Bitleitungen und Wortleitungen bzw. von ersten und zweiten Leitungen angesteuert werden, gleichzeitig gelöscht werden. Somit ist bei festkörperelektrolytischen Halbleiterspeichern noch keine Möglichkeit bekannt, einzelne Speicherzellen selektiv zu löschen.

Es wäre wünschenswert, einen integrierten Halbleiterspeicher mit resistiv schaltenden Speicherzellen bereitzustellen, dessen Speicherzellen unabhängig voneinander und selektiv zu den jeweils übrigen Speicherzellen gelöscht werden können. Der bereitzustellende Halbleiterspeicher soll insbesondere auch im Falle festkörperelektrolytischer Speicherzellen, deren Löschspannungen über einen größeren Spannungsbereich verteilt sind als deren Schreibspannungen, einen selektiven Zugriff auf einzelne Speicherzellen beim Löschen ermöglichen. Ferner soll ein Verfahren bereitgestellt werden, mit dem ein selektiver Löschvorgang an einzelnen Speicherzellen eines solchen Halbleiterspeichers durchführbar ist.

Diese Aufgabe wird erfindungsgemäß durch einen Halbleiterspeicher mit einer Anordnung nichtflüchtiger Speicherzellen gelöst, bei dem die Anordnung eine Vielzahl von ersten Leitungen und zweiten Leitungen aufweist, die zum Programmieren und Löschen von Speicherzellen elektrisch vorspannbar sind,

- wobei jede Speicherzelle an eine erste Leitung und eine zweite Leitung angeschlossen ist und einen Schichtenstapel aufweist, der einen Festkörperelektrolyten aufweist und zwischen der jeweiligen ersten Leitung und der jeweiligen zweiten Leitung angeordnet sind, an die die Speicherzelle angeschlossen ist,
- wobei die Schichtenstapel der Speicherzellen so ausgebildet sind, dass ihr ohmscher Widerstand durch die Höhe einer zwischen der jeweiligen ersten Leitung und der jeweiligen zweiten Leitung anliegenden Spannung veränderbar ist und bei ausreichend hoher positiver Spannung einen ersten Wert und bei ausreichend hoher negativer Spannung einen anderen, zweiten Wert annimmt,
- wobei die ersten Leitungen und die zweiten Leitungen so ansteuerbar sind, dass zum selektiven Löschen einer ausgewählten Speicherzelle selektiv zu allen übrigen Speicherzellen der Anordnung von Speicherzellen elektrische Potentiale aller ersten Leitungen und aller zweiten Leitungen in der Weise geändert werden, dass diejenige erste Leitung, an die die ausgewählte Speicherzelle angeschlossen ist, selektiv zu allen anderen ersten Leitungen mit einem ersten Potential vorgespannt und diejenige zweite Leitung, an die die ausgewählte Speicherzelle angeschlossen ist, selektiv zu allen anderen zweiten Leitungen mit einem zweiten Potential vorspannbar ist und alle anderen ersten Leitungen mit einem dritten Potential und alle anderen zweiten Leitungen mit einem vierten Potential vorgespannt werden,

- wobei die Potentialdifferenz zwischen dem ersten Potential und dem zweiten Potential größer ist als ein Grenzwert für eine Löschspannung, oberhalb dessen eine beliebige Speicherzelle der Anordnung zuverlässig gelöscht wird, und
- wobei das dritte und das vierte Potential so bemessen sind, dass während des selektiven Löschens der ausgewählten Speicherzelle an den anderen Speicherzellen anliegende Spannungen so gering sind, dass Löschvorgänge und Programmiervorgänge in den anderen Speicherzellen verhindert werden.

Erfindungsgemäß ist vorgesehen, dass ein integrierter Halbleiterspeicher, der als Speicherelemente Schichtenstapel mit einem Festkörperelektrolyten aufweist, die ersten und die zweiten Leitungen so ansteuert, dass die festkörperelektrolytischen Speicherzellen einzeln, d. h. selektiv zu den übrigen Speicherzellen, löschbar sind. Bislang sind keine Halbleiterspeicher auf der Basis von Festkörperelektrolyten bekannt, in denen zusätzlich zu den Schreib-, d. h. Programmiervorgängen auch die Löschvorgänge selektiv an einzelnen Speicherzellen durchführbar sind. Die vorliegende Erfindung hingegen ermöglicht es, durch die spezielle Wahl der Potentiale, mit denen die ersten und zweiten Leitungen vorgespannt werden, auch den Löschvorgang auf eine einzige Speicherzelle zu begrenzen, ohne dass Speicherinhalte der anderen Speicherzellen verloren gehen.

Um zu verhindern, dass die weiteren Speicherzellen, die an dieselbe erste Leitung oder dieselbe zweite Leitung angeschlossen sind wie die zu löschende Speicherzelle, unbeabsichtigt umprogrammiert werden, werden erfindungsgemäß auch alle übrigen ersten und zweiten Leitungen elektrisch vorgespannt, jedoch mit anderen Vorspannungen als die ausgewählte erste und zweite Leitung.

Der Erfindung liegt somit ferner die Idee zugrunde, einen zusätzlichen Freiheitsgrad der elektrischen Ansteuerung zu nutzen, nämlich die Höhe des Potentials derjenigen ersten und zweiten Leitungen, an welche die ausgewählte, zu löschende Speicherzelle gerade nicht angeschlossen ist und die daher an einem Löschvorgang eigentlich unbeteiligt sind. Durch die Grundidee, auch diese weiteren ersten und zweiten Leitungen in geeigneter Art elektrisch vorzuspannen gegenüber demjenigen Potential, das diese Leitungen sonst, wenn die Informationen sämtlicher Speicherzellen aufrechterhalten werden, besitzen, lässt sich ein Umprogrammieren derjenigen Speicherzellen, die die entweder nur an die ausgewählte erste Leitung oder nur an die ausgewählte zweite Leitung angeschlossen sind, verhindern. Dadurch lässt sich erstmals eine einzige festkörperelektrolytische Speicherzelle selektiv zu allen übrigen Speicherzellen derselben Anordnung von Speicherzellen löschen.

Vorzugsweise ist vorgesehen, dass die Schichtenstapel der Speicherzellen dann, wenn ihr ohmscher Widerstand den ersten Wert annimmt, hochohmig sind und dann, wenn ihr ohmscher Widerstand den zweiten Wert annimmt, niederohmig sind.

So wird ein hochohmiger Zustand erzeugt, indem eine betragsmäßig ausreichend hohe Spannung, die ein positives Vorzeichen besitzt, an den jeweiligen Schichtenstapel angelegt wird. Gemäß der hier verwendeten Konvention wird der Schichtenstapel niederohmig, wenn das Potential der zweiten Leitung deutlich kleiner ist als das der ersten Leitung, an die die jeweilige Speicherzelle angeschlossen ist.

Vorzugsweise ist vorgesehen, dass der Halbleiterspeicher die Größe des ohmschen Widerstandes der Schichtenstapel so auswertet, dass hochohmige Speicherzellen als gelöschte Speicherzellen und niederohmige Speicherzellen als programmierte Speicherzellen erfasst werden. Im gelöschten Zustand eines Speicherzellenfeldes sind daher alle Speicherzellen hochohmig. Eine niederohmig programmierte Speicherzelle entspricht beispielsweise einer digitalen "1". Durch die vorliegende Erfindung kann somit eine digitale "1" aus einer einzelnen Speicherzelle selektiv zu den übrigen Speicherzellen gelöscht, d.h. in eine digitale "0" umgewandelt werden. Alternativ kann auch eine digitale "0" einem niederohmigen Speicherzustand und eine digitale "1" einem hochohmigen Speicherzustand entsprechen. In diesem Fall wird beim selektiven Löschen eine digitale "0" in eine digitale "1" umgewandelt.

Hinsichtlich der Höhe der an die ersten und die zweiten Leitungen anzulegenden elektrischen Potentiale sieht eine bevorzugte Ausführungsform vor, dass das erste, das zweite, das dritte und das vierte Potential durch die im Anspruch 4 angegebenen Gleichungen vorgegeben sind, wobei V1 das erste, V2 das zweite, V3 das dritte und V4 das vierte Potential bezeichnet. Das erste Potential wird an die ausgewählte erste Leitung, an die die zu löschende Speicherzelle angeschlossen ist, angelegt. Das zweite Potential wird an die zweite Leitung, an die die zu löschende Speicherzelle angeschlossen ist, angelegt. An die übrigen ersten Leitungen wird das dritte Potential und an die übrigen zweiten Leitungen das vierte Potential angelegt.

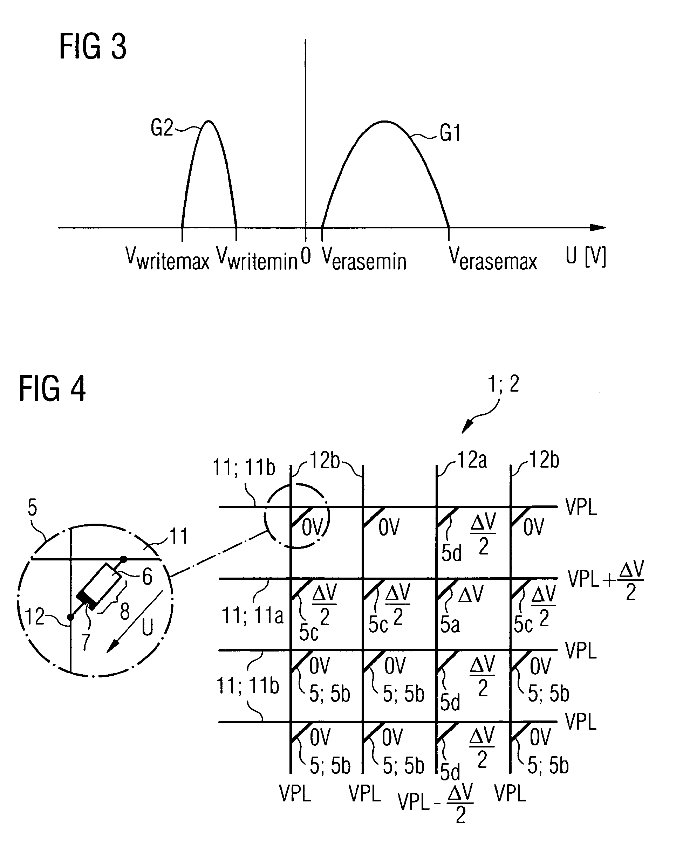

In den Gleichungen des Unteranspruchs 4, die die Höhe dieser Potentiale angeben, ist VPL ein beliebiges Referenzpotential und Verasemax ein Grenzwert für eine Löschspannung, oberhalb dessen eine beliebige Speicherzelle zuverlässig gelöscht wird. Dieser Grenzwert wird noch nachstehend beschrieben werden; er befindet sich in Figur 3 am rechten äusseren Ende der im Bereich positiver Spannungen U liegenden Verteilung von Schwellenspannungen für den Übergang in den hochohmigen Zustand. In den Gleichungen für die Höhe der Spannungen, die an die ersten und zweiten Leitungen anzulegen sind, bezeichnet OD eine reelle Zahl, die mindestens Eins beträgt, und EI eine reelle Zahl, die höchstens Eins beträgt. Die Größe des Parameters OD entspricht einem Faktor, um den das zum Löschen der Speicherzelle verwendete erste Potential im Verhältnis zur Höhe des Potentials Verasemax überhöht ist. Dadurch führt der Löschvorgang noch sicherer und schneller zum Löschen der Speicherzelle.

Der Parameter EI beschreibt einen Faktor, der Obergrenzen für die Größe der Parameter c und d festlegt. Durch die Parameter c und d wird Höhe der Potentiale V3 und V4 der übrigen ersten und zweiten Leitungen beeinflußt. Der Faktor EI beschreibt, um welchen Faktor eine an die übrigen Leitungen angelegten Potentiale kleiner ausfallen als eigentlich möglich, wenn die an den übrigen Speicherzellen angelegten Spannungen den Spannungsbereich zwischen den Verteilungen der Schreib- und der Löschspannungen ausnutzen würden. Durch den Faktor EI wird zusätzliche Sicherheit gegenüber einem unbeabsichtigtem Umprogrammieren der übrigen Speicherzellen erzielt.

Der Parameter Verasemax bezeichnet einen Grenzwert für eine Löschspannung, oberhalb dessen eine beliebige Speicherzelle zuverlässig gelöscht wird. Dies bedeutet, dass dieser Grenzwert das obere Ende der Bandbreite von Schwellspannungen angibt, bei denen zunächst niederohmig programmierte Speicherzellen hochohmig werden. Da bei einem Halbleiterspeicher, der resistiv schaltbare Festkörperelektrolyt-Elemente aufweist, für jede Speicherzelle die Schwellspannungen unterschiedlich hoch sind, kann für eine Vielzahl von Speicherzellen eines Speicherzellenfeldes lediglich eine relativ große Bandbreite einer statistischen Verteilung angegeben werden kann, innerhalb derer die Schwellenspannungen der einzelnen Speicherzellen liegen. Verasemax bezeichnet das obere Ende der Verteilung der Löschspannungen, bei dem jede Speicherzelle, sofern mit dieser Spannung vorgespannt, zuverlässig hochohmig wird. Die Programmierspannung kann durchaus höher sein, sie muss jedoch größer sein als Verasemax. Der Quotient aus der verwendeten Löschspannung und Verasemax ist durch den Parameter OD beschrieben.

Verasemin bezeichnet diejenige Spannung, die an der unteren Grenze der Verteilung der Schwellspannungen für den Übergang von dem niederohmigen in den hochohmigen Zustand liegt. Entsprechend bezeichnet Vwritemin die obere Grenze der Bandbreite der (negativen) Schwellenspannungen für den Übergang von dem hochohmigen in den niederohmigen Zustand, d.h. den vom Betrag her kleinsten, auf der Spannungsskala U größten Spannungswert innerhalb der Verteilung der Schreibspannungen.

Vorzugsweise ist vorgesehen, dass die Parameter a, b, c und d beliebige reelle Zahlen sind. Diese Parameter können der Einfachheit halber jedoch auch als ganze Zahlen und insbesondere als natürliche Zahlen einschliesslich der Null gewählt werden. Eine wesentliche inhaltliche Einschränkung ergibt sich daraus nicht, sofern berücksichtigt wird, dass jeder beliebige Zahlenwert in ausreichend guter Näherung durch eine gebrochen rationale Zahl dargestellt werden kann.

Eine Ausführungsform sieht vor, dass der Parameter a den Wert Null besitzt. Dadurch verändern sich zwar die Werte der an den ersten und zweiten Leitungen anliegenden Potentiale V1, V2, V3 und V4, jedoch bleiben die an den Speicherzellen anliegenden Spannungen, die sich aus der Differenz jeweils zweier dieser Potentiale ergeben, unverändert. Der Parameter a verschiebt lediglich das Potential sämtlicher erster und zweiter Leitungen beim selektiven Löschen einer bestimmten Speicherzelle gegenüber demjenigen Referenzpotential VPL, das sonst an den ersten und zweiten Leitungen anliegt, wenn die Programmierzustände sämtlicher Speicherzellen unverändert aufrechterhalten werden.

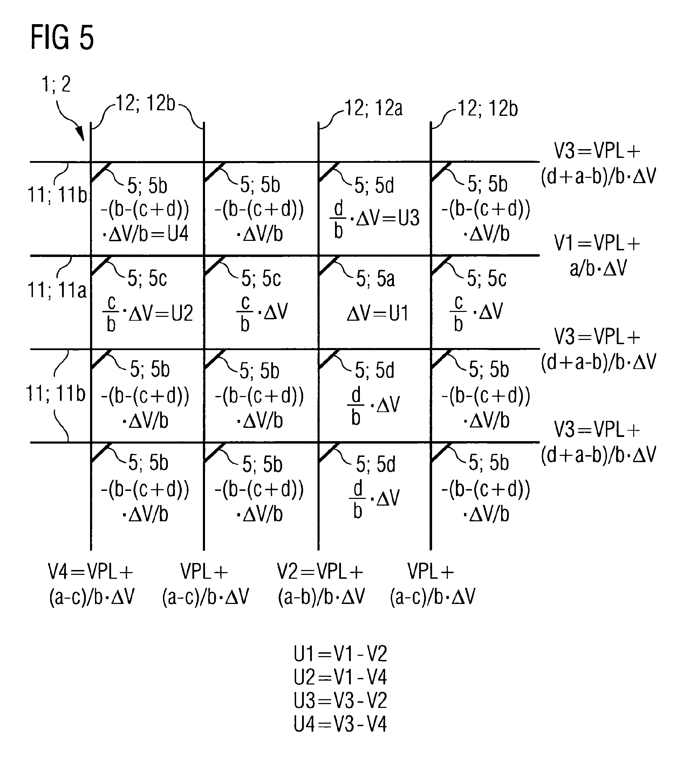

Eine weitere bevorzugte, vorteilhafte Ausführungsform sieht vor, dass die Parameter c und d gleich groß gewählt sind. In diesem Fall ist die Differenz zwischen den Potentialen V1 und V3 genauso groß wie die Differenz zwischen den Potentialen V2 und V4. Dies führt dazu, dass diejenigen Speicherzellen 5c und 5d (Figur 5), die entweder nur an die selektierte erste Leitung oder an die selektierte zweite Leitung angeschlossen sind, alle mit einer gleich grossen Spannung vorgespannt sind. Daher ist für alle diese Speicherzellen ein gleich großer Sicherheitfaktor gegen unbeabsichtigtes Umprogrammieren gewonnen, und zwar unabhängig davon, ob die jeweilige Speicherzelle an dieselbe erste Leitung wie die zu löschende Speicherzelle oder an dieselbe zweite Leitung wie die zu löschende Speicherzelle angeschlossen ist.

Vorzugsweise ist vorgesehen, dass der Halbleiterspeicher so ausgebildet ist, dass alle ersten Leitungen und alle zweiten Leitungen dann, wenn der Speicherzustand aller Speicherzellen unverändert aufrechterhalten wird, mit dem Referenzpotential vorgespannt sind.

Vorzugsweise ist vorgesehen, dass die Parameter b, c und d so gewählt sind, dass an denjenigen Speicherzellen (5b in Figur 5), die weder an die mit dem ersten Potential vorgespannte erste Leitung noch an die mit dem zweiten Potential vorgespannte zweite Leitung angeschlossen sind, eine negative Spannung anliegt. Diese Ausführungsform ist deshalb von Vorteil, weil die Bandbreite der Schwellwerte für Löschspannungen näher an den Spannungswert 0 Volt heranreicht als die Bandbreite der Schwellwerte für die Programmierspannungen. Zum selektiven Löschen einer Speicherzelle (der Speicherzelle 5a in Figur 5) wird das Potential der betreffenden ersten Leitung (11a in Figur 5), an die die Speicherzelle angeschlossen ist, erhöht und das Potential der betreffenden zweiten Leitung (12a in Figur 5) abgesenkt. Um zu verhindern, dass die weiteren Speicherzellen (5c, 5d in Figur 5), die an dieselbe erste Leitung oder dieselbe zweite Leitung angeschlossen sind wie die ausgewählte Speicherzelle (5a in Figur 5), ebenfalls gelöscht werden, kann das Potential der übrigen ersten Leitungen abgesenkt und das der übrigen zweiten Leitungen erhöht werden. Dadurch liegen an den übrigen Speicherzellen (5b in Figur 5) negative Spannungen an, deren Betrag jedoch ausreichend klein sein muss, damit diese Speicherzellen 5b nicht programmiert werden. Die an diese Speicherzellen 5b angelegte (negative) Spannung kann jedoch kleiner (und vom Betrag her grösser) gewählt werden als -Verasemin, d.h. sie kann innerhalb des Intervalls zwischen Vwritemin und Verasemin einen beliebigen Wert annehmen, der insbesondere zwischen Vwritemin und -Verasemin liegen kann. Dadurch wird die Asymmetrie der Schwellwertverteilungen, die noch anhand der Figur 3 erläutert werden wird, Rechnung getragen. Somit können an die Speicherzellen 5b kleinere, d.h. negative, doch vom Betrag her grössere Spannungen angelegt werden als -Verasemin. Dadurch wird ferner dem Umstand Rechnung getragen, dass Verasemin für heutige festkörperelektrolytische Halbleiterspeicher kleiner ist als der Betrag von Vwritemin. Der dadurch erzielte Sicherheitsgewinn ist umso größer, als die Anzahl derjenigen Speicherzellen (5b in Figur 5), die weder an dieselbe erste Leitung noch an dieselbe zweite Leitung wie die zu löschende Speicherzelle angeschlossen sind, zahlenmäßig deutlich überwiegt, so dass bei dieser Ausführungsform die größtmögliche Sicherheit gegenüber Fehlprogrammierungen innerhalb des Speicherzellenfeldes erzielt wird.

Dememtsprechend ist vorzugsweise vorgesehen, dass die Parameter b, c und d so gewählt sind, dass der Betrag der Spannung, die an denjenigen Speicherzellen (5b in Figur 5) anliegt, die weder an die mit dem ersten Potential vorgespannte erste Leitung noch an die mit dem zweiten Potential vorgespannte zweite Leitung angeschlossen sind, größer ist als der Grenzwert (Verasemin) für eine positive Spannung, unterhalb dessen ein Löschvorgang zuverlässig verhindert wird, und kleiner ist als der Betrag des Grenzwerts (Vwritemin) für eine negative Spannung, oberhalb dessen ein Programmiervorgang zuverlässig verhindert wird. Somit liegt an allen diesen Speicherzellen 5b eine insgesamt negative Spannung an, deren Absolutwert jedoch zwischen den Absolutwerten der Parameter Verasemin und Vwritemin liegt, wobei Verasemin positiv ist, Vwritemin jedoch negativ ist und einen größeren Absolutwert besitzt als Verasemin. Diese Ausführungsform eröffnet einen Spannungsbereich für Vorspannungen, die an die durch die nicht selektierten ersten und zweiten Leitungen angeschlossenen Speicherzellen 5b angelegt werden, der eine besonders großen Abstand zur Verteilung der Schwellwerte für Löschspannungen besitzt

Ferner ist vorgesehen, dass die Parameter b, c und d so gewählt sind, dass beim Löschen der ausgewählten Speicherzelle (5a in Figur 5) die Größe der an den anderen Speicherzellen (5b, 5c und 5d in Figur 5) anliegenden Spannungen kleiner ist als der Grenzwert für eine positive Spannung, unterhalb dessen ein Löschvorgang zuverlässig verhindert wird, aber größer ist als der Grenzwert für eine negative Spannung, oberhalb dessen ein Programmiervorgang zuverlässig verhindert wird. Die an den übrigen Speicherzellen (5b, 5c und 5d) anliegenden Spannungen liegen dann alle zwischen den Parametern Verasemin und Vwritemin. Dazu sind nach Festlegung der Parameter a und b insbesondere die im Anspruch 4 enthaltenen Ungleichungen für die Parameter c und d einzuhalten.

Hinsichtlich des Aufbaus der Speicherzellen ist vorzugsweise vorgesehen, dass die Schichtenstapel der Speicherzellen auf einer Seite des Festkörperelektrolyten eine metallhaltige Schicht aufweisen, aus der dann, wenn an dem jeweiligen Schichtenstapel eine ausreichend hohe Schreibspannung anliegt, Metallionen in den Festkörperelektrolyten hineindiffundieren. Dadurch wird die Speicherzelle niederohmig. Wird hingegen eine ausreichend hohe Löschspannung angelegt, so diffundieren die Metallionen aus dem Festkörperelektrolyten zurück in die metallhaltige Schicht und die Speicherzelle wird hochohmig. Die metallhaltige Schicht ist im einfachsten Fall eine Metallschicht oder eine Schicht aus einer Metallegierung. Sie kann beispielsweise Silber enthalten.

Es ist beispielsweise vorgesehen, dass die Materialzusammensetzung des Festkörperelektrolyten und der metallhaltigen Schicht so beschaffen ist, dass Schwellwerte für Löschspannungen, bei denen niederohmige Speicherzellen hochohmig werden, und Schwellwerte für Programmierspannungen, bei denen hochohmige Speicherzellen niederohmig werden, für die Vielzahl von Speicherzellen statistisch über Spannungsbereiche verteilt sind, wobei die Schwellwerte für Löschspannungen über einen größeren Spannungsbereich verteilt sind als die Schwellwerte für Programmierspannungen. Dies ist bei festkörperelektrolytischen Speicherzellen der Fall. Jedoch können mit Hilfe der vorliegenden Erfindung grundsätzlich auch Halbleiterspeicher betrieben werden, bei denen die Bandbreite der Programmierspannungen größer ist als die Bandbreite der Löschspannungen.

Es ist beispielsweise vorgesehen, dass die Materialzusammensetzung des Festkörperelektrolyten und der metallhaltigen Schicht so beschaffen ist, dass der Grenzwert für eine positive Spannung, unterhalb dessen ein Löschvorgang zuverlässig verhindert wird, kleiner ist als der Betrag des Grenzwertes für eine negative Spannung, oberhalb dessen ein Programmiervorgang zuverlässig verhindert wird. Somit ist der Parameter Vwritemin zwar negativ, betragsmäßig jedoch größer als der Parameter Verasemin.

Es ist beispielsweise ferner vorgesehen, dass die Spannungsabhängigkeit des ohmschen Widerstands der Schichtenstapel so beschaffen ist, dass der Grenzwert für eine Löschspannung, oberhalb dessen eine beliebige Speicherzelle zuverlässig gelöscht wird, größer ist als der Betrag des Grenzwerts für eine Programmierspannung, unterhalb dessen eine beliebige Speicherzelle zuverlässig programmiert wird. Insbesondere kommen hierfür festkörperelektrolytische Speicherzellen in Frage, bei denen die Bandbreite der Löschspannung bis hin zu betragsmäßig kleineren Spannungswerten reicht als die Bandbreite der Programmierspannungen.

Vorzugsweise ist vorgesehen, dass der Festkörperelektrolyt der Schichtenstapel ein glasförmiges Material enthält. Der Festkörperelektrolyt in den Schichtenstapeln kann insbesondere ein Chalcogenid enthalten, beispielsweise kann in dem Festkörperelektrolyten eine Verbindung aus Silber, Germanium und Selen enthalten sein. In dieses Material können insbesondere Silberionen eindiffundieren. Somit kann die metallhaltige Schicht beispielsweise eine reine Silberschicht sein.

Schließlich ist vorgesehen, dass die ersten Leitungen und die zweiten Leitungen auf zueinander entgegengesetzten Seiten der Schichtenstapel angeordnet sind.

Die Erfindung wird nachstehend mit Bezug auf die Figuren beschrieben. Es zeigen:

Figur 1 eine schematische Draufsicht auf einen integrierten Halbleiterspeicher mit einer Anordnung nichtflüchtiger Speicherzellen,

Figur 2 eine perspektivische Ansicht einer Speicherzelle des Halbleiterspeichers aus Figur 1,

Figur 3 die Spannungsabhängigkeit der Schwellwerte für Schreib- und Löschspannungen eines festkörperelektrolytischen Halbleiterspeichers,

Figur 4 eine schematische Darstellung eines Speicherzellenfeldes eines Halbleiterspeichers mit ersten und zweiten Leitungen sowie daran engelegte elektrische Potentiale zur Veranschaulichung der Problemstellung der Erfindung und

Figur 5 eine schematische Darstellung eines Speicherzellenfeldes eines erfindungsgemäßen Halbleiterspeichers mit der erfindungsgemässen Ansteuerung seiner Leitungen beim selektiven Löschen einer einzelnen Speicherzelle.

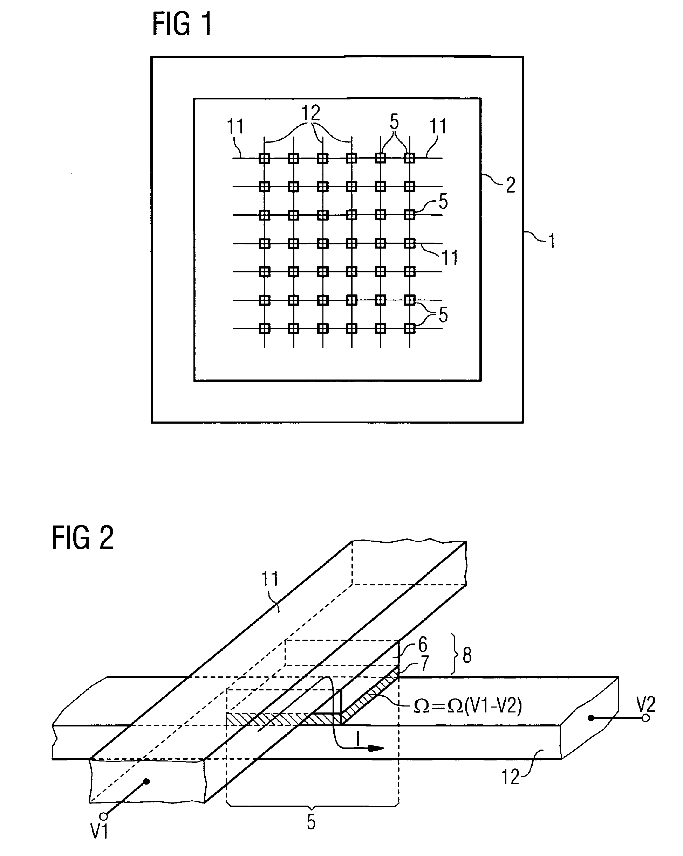

Figur 1 zeigt eine schematische Draufsicht auf einen integrierten Halbleiterspeicher 1 mit einer Anordnung 2 nichtflüchtiger Speicherzellen 5. Die Anordnung 2 besitzt ferner eine Vielzahl erster Leitungen 11 und zweiter Leitungen 12, die zum Programmieren und Löschen der Speicherzellen 5 elektrisch vorspannbar sind. Jede Speicherzelle 5 ist an genau eine erste Leitung 11 und an genau eine zweite Leitung 12 angeschlossen; die Anordnung 2 bildet ein Cross-Point-Array, dessen Speicherzellen 5 insbesondere festkörperelektrolytische Speicherzellen sind, die keinen Auswahltransistor benötigen.

Figur 2 zeigt eine perspektivische Ansicht einer Speicherzelle 5 des Halbleiterspeichers 1 aus Figur 1. Dort, wo eine erste Leitung 11 eine zweite Leitung 12 überkreuzt, ist zwischen der ersten Leitung 11 und der zweiten Leitung 12 ein Schichtenstapel 8 angeordnet, der die erste Leitung 11 mit der zweiten Leitung 12 verbindet. Somit kann über die erste Leitung 11, den Schichtenstapel 8 und die zweite Leitung 12 ein Strom I geleitet werden, indem die erste Leitung 11 und die zweite Leitung 12 mit voneinander verschiedenen elektrischen Potentialen V1, V2 vorgespannt werden. Der Schichtenstapel 8 weist eine Schicht aus einem Festkörperelektrolyten 6 auf sowie eine daran angrenzende metallhaltige Schicht 7. Die metallhaltige Schicht 7 enthält ein Metall wie beispielsweise Silber, das in ionischer Form in die Schicht auf dem Festkörperelektrolyten 6 eindiffundieren kann, sofern eine negative Spannung ausreichend großen Betrags zwischen der ersten Leitung 11 und der zweiten Leitung 12 anliegt. Dadurch verändert sich der ohmsche Widerstand des Schichtenstapels 8; die Speicherzelle 5 wird niederohmig.

Figur 3 zeigt die Abhängigkeit der Schwellwerte für die Schreib- und Löschspannungen des festkörperelektrolytischen Halbleiterspeichers aus Figur 1. In Abhängigkeit von der an eine beliebige Speicherzelle angelegte Spannung U ist die Häufigkeit aufgetragen, mit der bei einem integrierten Halbleiterspeicher mit einer größeren Anzahl festkörperelektrolytischer Speicherzellen ein bestimmter Schwellwert für eine bestimmte Höhe der Löschspannung bzw. Schreibspannung vorkommt. Die Funktionswerte entsprechen somit der Anzahl von Speicherzellen, bei denen die Schwellspannungen gerade den betreffenden Wert U annehmen.

Die Schwellwerte G1 für die Löschspannungen besitzen eine relativ große Bandbreite zwischen den zwei Grenzwerten Verasemin und Verasemax. Verasemax ist ein Grenzwert für eine Löschspannung, oberhalb dessen eine beliebige Speicherzelle zuverlässig gelöscht wird. Verasemin ist ein Grenzwert für eine positive Spannung, unterhalb dessen ein Löschvorgang zuverlässig verhindert wird. Dazwischen liegt die Verteilung derjenigen Spannungswerte, bei denen für die Speicherzellen des Halbleiterspeichers der Speicherzustand von dem niederohmigen Speicherzustand in den hochohmigen Speicherzustand umschlägt. Daher wird jeweils durch eine positive Spannung ein anfänglich niederohmiger Speicherzustand in einen hochohmigen Speicherzustand umgewandelt. Für jede Speicherzelle liegt diejenige Schwellspannung, bei der gerade diese Änderung des Speicherzustands erfolgt, im Bereich der Verteilung zwischen Verasemin und Verasemax. Da zum zuverlässigen Löschen von Informationen in einer beliebigen Speicherzelle des Halbleiterspeichers eine Löschspannung gewählt werden muss, bei der das Erreichen des hochohmigen Zustands unabhängig von der individuell angesteuerten Speicherzelle ist, werden bei einem festkörperelektrolytischen Halbleiterspeicher Löschspannungen gewählt, die größer sind als Verasemax. Ebenso dürfen Spannungen, die an anderen Speicherzellen anliegen, nicht größer sein als Verasemin, wenn vermieden werden soll, dass diese anderen Speicherzellen unbeabsichtigt gelöscht werden.

Die Schwellwerte G2 für die Schreibspannungen liegen im Bereich negativer Spannungen und besitzen eine kleinere Bandbreite als die Schwellwerte G1 für die Löschspannung. Vwritemax ist ein Grenzwert für eine Programmierspannung, unterhalb derer eine beliebige Speicherzelle zuverlässig programmiert wird. Dies bedeutet, dass bei einer negativen Spannung, die betragsmäßig größer ist als Vwritemax, mit Sicherheit jede beliebige Speicherzelle, die mit dieser Spannung vorgespannt wird, niederohmig geschaltet und somit beschrieben wird. Vwritemin ist ein Grenzwert für eine negative Spannung, oberhalb dessen ein Programmiervorgang zuverlässig verhindert wird. Die Bandbreite der Schwellwerte G2 für die Schreibspannungen reicht somit von Vwritemin bis Vwritemax und ist so klein, dass es möglich ist, Informationen in einzelne Speicherzellen 5 des Halbleiterspeichers 1 aus Figur 1 zu schreiben, ohne dass in weitere Speicherzellen gleichzeitig weiter Informationen geschrieben werden. Da, wie anhand von Figur 1 erkennbar, an jede erste Leitung 11 ebenso wie an jede zweite Leitung 12 jeweils eine Vielzahl von Speicherzellen 5 angeschlossen ist, würde ein Vorspannen einer ersten oder zweiten Leitung mit einer Spannung, die betragsmäßig größer ist als Verasemax oder Vwritemax, dazu führen, dass sämtliche an die betroffene Leitung angeschlossenen Speicherzellen umprogrammiert würden. Ein selektiver Programmierzugriff auf eine einzelne Speicherzelle lässt sich daher nur dadurch durchführen, dass an jeweils eine ausgewählte erste Leitung und eine ausgewählte zweite Leitung Teilspannungen angelegt werden, die an derjenigen Speicherzelle 5, die im Schnittpunkt der ausgewählten ersten Leitung und der ausgewählten zweiten Leitung liegt, zusammen die zum Umprogrammieren erforderliche Spannung ergeben. Dadurch wird ein unbeabsichtigtes Umprogrammieren der übrigen Speicherzellen, die entweder an dieselbe erste Leitung oder an dieselbe zweite Leitung wie die zu programmierende Speicherzelle angeschlossen sind, vermieden.

Dieses Vorgehen ist nur deshalb durchführbar, weil die Verteilung der Schwellwerte G2 der Schreibspannungen eine relativ kleine Bandbreite besitzt. Ein vergleichbares Vorgehen zum selektiven Löschen einer individuellen Speicherzelle ist jedoch nicht bekannt und auch nicht möglich, weil die Schwellwerte G1 der Löschspannungen eine wesentlich breitere Bandbreite auf der Spannungsskala besitzen. In festkörperelektrolytischen Halbleiterspeichern müssten daher mindestens ganze Spalten, Zeilen oder Blöcke von Speicherzellen gemeinsam gelöscht werden.

Dieser Zugriff beim Schreiben kann beispielsweise dadurch erfolgen, dass das Potential der zum Löschen ausgewählten ersten Leitung, an die die zu löschen Speicherzelle angeschlossen ist, um die Hälfte der negativen Schreibspannung abgesenkt und das Potential der zum Löschen ausgewählten zweiten Leitung, an die die zu löschende Speicherzelle angeschlossen ist, um die Hälfte der Schreibspannung erhöht wird. An der ausgewählten Speicherzelle liegt dann eine negative Spannung an, die der Schreibspannung entspricht und betragsmäßig größer ist als Vwritemax. Diejenigen weiteren Speicherzellen, die an dieselbe erste Leitung angeschlossen sind, erfahren eine negative Spannung, die halb so groß ist wie die zum selektiven Programmieren verwendete Spannung. Da jedoch die Bandbreite der Schwellwerte G2 zum Programmieren relativ klein ist, ist die dort anliegende halb so große Spannung betragsmäßig so klein, dass sie in Figur 3 rechts von dem Grenzwert Vwritemin liegt und somit nicht zum unbeabsichtigten Programmieren weiterer Speicherzellen führen kann. Auch diejenigen Speicherzellen, die an dieselbe zweite Leitung angeschlossen sind wie die zu programmierende Speicherzelle, sind gegen gleichzeitiges Überschreiben geschützt. An ihnen liegt ebenfalls eine Spannung in Höhe der Hälfte der Schreibspannung an, da das Potential der zweiten Leitung um eben diesen Betrag abgesenkt wurde.

Figur 4 zeigt schematisch ein Speicherzellenfeld eines Halbleiterspeichers mit ersten und zweiten Leitungen sowie die an diesen Leitungen anliegenden Potentiale und die sich daraus für die Speicherzellen ergebenden Spannungen, und zwar für den Fall, dass dasselbe Vorgehen für das selektive Löschen einer einzelnen Speicherzelle angewandt wird. Dieses Vorgehen funktioniert wegen der weiteren Bandbreite der Löschspannungen nicht, jedoch soll anhand der Figur 4 die Problemstellung der vorliegenden Erfindung deutlich werden.

Die in Figur 4 lediglich schematisch dargestellte Anordnung 2 von Speicherzellen 5 des Halbleiterspeichers 1 enthält erste Leitungen 11 und zweite Leitungen 12, von denen jeweils eine ausgewählte erste Leitung 11a und eine ausgewählte zweite Leitung 12a vorgespannt werden, um die Speicherzelle 5a, die an ihrem Kreuzungsort liegt, selektiv zu den übrigen Speicherzellen 5b, 5c, 5d zu löschen. In einer Ausschnittvergrößerung ist ein Beispiel für eine mögliche Orientierung der Speicherzellen 5 dargestellt; in der Ausschnittvergrößerung ist zu erkennen, dass die jeweilige Schicht aus dem Festkörperelektrolyten 6 jeweils an eine erste Leitung 11 und die metallische Schicht 7 des Schichtenstapels 8 an die jeweilige zweite Leitung 12 angeschlossen ist. Die Spannung U wird dann als positiv bezeichnet, wenn das Potential der ersten Leitung 11 größer ist als das Potential der zweiten Leitung 12, an welche die Speicherzelle 5 angeschlossen ist. In Figur 4 ist eine Matrix von 4 x 4 Speicherzellen dargestellt. Würde, wie oben für das selektive Programmieren einer einzelnen Speicherzelle beschrieben, auch die Löschspannung zum Löschen einer einzelnen Speicherzelle in zwei gleich große Teilspannungen halb so großen Betrages aufgeteilt, so würde etwa an die ausgewählte erste Leitung 11a eine Teilspannung von $\Delta V/2$ gegenüber einem Referenzpotential VPL angelegt. Ferner würde an eine ausgewählte zweite Leitung 12a eine Teilspannung von $-\Delta V/2$ angelegt, so dass die am Kreuzungsort der Leitungen 11a, 12a angeordnete Speicherzelle 5a eine Löschspannung von $\Delta V$ erfährt und gelöscht wird. An denjenigen Speicherzellen 5c, die an dieselbe erste Leitung 11a, jedoch an eine andere zweite Leitung 12b angeschlossen sind als die ausgewählte Speicherzelle 5a, liegt eine Löschspannung der Höhe $\Delta V/2$ an, da das Potential der ausgewählten ersten Leitung 11a eben diesem Betrag entspricht. Auch an denjenigen Speicherzellen 5d, die lediglich an dieselbe zweite Leitung 12a wie die Speicherzelle 5a angeschlossen sind, liegt ebenfalls eine Spannung der Höhe $\Delta V/2$ an.

Aus Figur 3 ist ersichtlich, dass die zum erfolgreichen Löschen erforderliche Löschspannung mindestens so groß sein muss wie Verasemax. Es genügt, wenn die Löschspannung geringfügig größer gewählt wird als Verasemax. Die Hälfte der verwendeten Löschspannung, die den Wert $\Delta V/2$ entspricht, liegt jedoch innerhalb der Bandbreite der Verteilungen der Löschspannung, d. h. innerhalb der Bandbreite zwischen Verasemin und Verasemax. Je nachdem, wo für die an dieselbe erste Leitung 11a oder für die an dieselbe zweite Leitung 12a angeschlossenen Speicherzellen der jeweilige Schwellwert G1 für das Löschen liegt, werden diese Zellen gleichzeitig mit der Speicherzelle 5a gelöscht oder nicht gelöscht. Ein zuverlässiges Löschen ausschließlich der ausgewählten Speicherzelle 5a selektiv zu allen übrigen Speicherzellen, insbesondere zu den Speicherzellen 5c und 5d, ist somit nicht möglich. Grund dafür ist die große Bandbreite der Schwellwerte G1 für die Löschspannungen. Figur 4 verdeutlicht somit die der Erfindung zugrundeliegende Problemstellung, dass selbst bei Aufteilen einer Löschspannung auf diejenige erste Leitung und diejenige zweite Leitung, an die eine individuelle Speicherzelle angeschlossen ist, diese Speicherzelle nicht selektiv zu allen übrigen Speicherzellen gelöscht werden kann, ohne dass das unbeabsichtigte Löschen weiterer Speicherzellen zuverlässig verhindert wird. Um dies zu erreichen, sind zusätzliche Maßnahmen erforderlich, die im erfindungsgemäß vorgeschlagenen Halbleiterspeicher verwirklicht sind.

Figur 5 zeigt schematisch ein Speicherzellenfeld des erfindungsgemäßen Halbleiterspeichers 1, das eine Anordnung 2 von Speicherzellen 5 aufweist, die durch die erfindungsgemäße speicherinterne Ansteuerung der ersten Leitung 11 und der zweiten Leitung 12 individuell, d. h. selektiv zu allen übrigen Speicherzellen löschbar sind. Zum Löschen einer ausgewählten Speicherzelle 5a wird eine ausgewählte erste Leitung 11a sowie eine ausgewählte zweite Leitung 12a, an die die ausgewählte, zu löschende Speicherzelle 5a angeschlossen ist, vorgespannt. Erfindungsgemäss werden erstens die Spannungsänderungen der ausgewählten Leitungen 11a, 12a der Höhe nach anders gewählt als in Figur 4. Erfindungsgemäss werden zweitens zugleich auch alle übrigen ersten Leitungen 11b und alle übrigen zweiten Leitungen 12b vorgespannt, und zwar mit geeignet gewählten Potentialen. Die kombinierte Wirkung dieser unterschiedlichen Vorspannungen sämtlicher erster und zweiter Leitungen 11a, 11b, 12a, 12b führt zu Spannungen an den Speicherzellen 5 in einer solchen Größe, dass eine individuelle ausgewählte Speicherzelle 5a selektiv löschbar ist und zugleich ein unbeabsichtigtes Löschen sämtlicher übrigen Speicherzellen zuverlässig ausgeschlossen wird.

Die in Figur 5 angegebenen Formeln für die Höhe der Potentiale V1, V2, V3 und V4, mit denen die ersten und zweiten Leitungen 11, 12 zum selektiven Löschen ausschließlich einer einzigen Speicherzelle 5a vorzuspannen sind, enthalten jeweils den Parameter VPL, womit eine Referenzspannung bezeichnet wird. Die Referenzspannung VPL kann beispielsweise diejenige Spannung sein, die dann, wenn kein Löschvorgang erfolgt und die Informationen sämtlicher Speicherzellen aufrechterhalten werden, an den ersten und zweiten Leitungen anliegt. Zusätzlich enthalten die Spannungen V1, V2, V3 und V4 den Parameter $\Delta V$, der die an der ausgewählten, zu löschenden Speicherzelle 5a angelegte Löschspannung angibt. Diese Löschspannung $U1 = \Delta V$ liegt ausschließlich an der zu löschenden Speicherzelle 5a an. Nach der Höhe dieser ersten Spannung U1 richten sich auch diejenigen Potentiale V1, V2, V3 und V4, die an die ersten und zweiten Leitungen 11, 12 erfindungsgemäß angelegt werden, um ein unbeabsichtigtes Löschen weiterer Speicherzellen 5c und 5d auszuschließen. In der Ausführungsform gemäß Figur 5 ergeben sich diese Potentiale aus den Gleichungen:

$$V1 = VPL + a / b * \Delta V$$

$$V2 = VPL + (a - b) / b * \Delta V$$

$$V3 = VPL + (d + a - b) / b * \Delta V$$

$$V4 = VLP + (a - c) / b * \Delta V$$

In diesen Gleichungen bezeichnen die Parameter a, b, c und d reelle Zahlen, die jedoch vereinfachend als ganze Zahlen und insbesondere als natürliche Zahlen einschließlich der Null gewählt werden können. Dadurch wird in den Gleichungen für die Potentiale V1 bis V4 die jeweilige Abweichung $\Delta V$ des Potentials der betreffenden Leitung mit einem Faktor versehen, der eine gebrochen rationale Zahl darstellt und jeweils den Parameter b im Nenner hat. Der Parameter a bestimmt die Höhe derjenigen ersten Leitung 11a, an die die zu löschende Speicherzelle 5a angeschlossen ist. Die Höhe des Potentials V2, mit der diejenige zweite Leitung 12a, an die die Speicherzelle 5a angeschlossen ist, ist gerade so gewählt, dass in der Speicherzelle 5a gerade die erste Spannung U1 in der Höhe der Löschspannung ΔV anliegt. Die Gleichung für die Höhe des vierten Potentials V4, mit dem die übrigen zweiten Leitungen 12b vorgespannt werden, enthält den weiteren Parameter c, welcher bewirkt, dass an denjenigen Speicherzellen 5c, die an die ausgewählte erste Leitung 11a, jedoch an eine andere zweite Leitung 12b als die zu löschende Speicherzelle 5a angeschlossen sind, mit einer zweiten Spannung U2 von c/b ΔV vorgespannt werden. Der Faktor c/b ist insbesondere kleiner als Eins, wird jedoch nachstehend noch genauer bestimmt werden. Die Gleichung für das Potential V3, mit dem die übrigen ersten Leitungen 11b vorgespannt werden, enthält den weiteren Parameter d. Dadurch liegt an denjenigen Speicherzellen 5d, die an die ausgewählte zweite Leitung 12a, jedoch an eine andere erste Leitung 11b als die zu löschende Speicherzelle 5a angeschlossen sind, mit der Spannung U3 = d/b ΔV gegenüber dem Referenzpotential VPL vorgespannt werden. Auch der Faktor d/b ist kleiner als Eins und wird nachstehend noch genauer bestimmt. In Figur 5 sind denjenigen Speicherzellen 5b, die weder an die ausgewählte erste Leitung 11a noch an die ausgewählte zweite Leitung 11b angeschlossen sind, mit der vierten Spannung von U4 = -(1-(c+d)/b) ΔV vorgespannt.

In den in Figur 5 angegebenen Gleichungen für die Potentiale V1 bis V4 und die Spannungen U1 bis U4 bezeichnet ΔV, wie schon oben beschrieben, die gewählte Löschspannung. Um ein unbeabsichtigtes Umprogrammieren der Speicherzellen 5b, 5c, 5d, insbesondere ein unbeabsichtigtes Löschen der Speicherzellen 5c und 5d sowie ein unbeabsichtigtes Programmieren der Speicherzellen 5b während des Löschens der Speicherzelle 5a zu vermeiden, werden die folgenden Bedingungen aufgestellt:

Bedingung 1: $\Delta V \geq V_{erase\,max}$

Bedingung 2: $\dfrac{c}{b} \Delta V \leq V_{erase\,min}$ ; $\dfrac{d}{b} \Delta V \leq V_{erase\,min}$

Bedingung 3: $\left(1 - \dfrac{c+d}{b}\right)\Delta V < |V_{write\,min}|$

Ferner wird ein Parameter OD (Overdrive) definiert, der größer oder gleich 1 ist und der angibt, um wieviel die Löschspannung ΔV für die zu löschende Speicherzelle 5a größer gewählt wird als der Grenzwert Verasemax. Somit gilt:

$$\Delta V = OD * Verasemax.$$

Ferner wird ein Parameter EI (Erase Inhibit) definiert, der kleiner oder gleich 1 ist und der angibt, um welchen Faktor an denjenigen Speicherzellen 5c und 5d, die entweder an die ausgewählte erste Leitung 11a oder an die ausgewählte zweite Leitung 12a angeschlossen sind, die anliegende Spannung betragsmäßig kleiner ist als Verasemin.

Durch Einsetzen der Parameter OD und EI in die Bedingung 2 ergibt sich:

$$\frac{c}{b} OD \cdot V_{erase\,max} = \frac{d}{b} OD \cdot V_{erase\,max} = EI \cdot V_{erase\,min}$$

und durch Einsetzen in Bedingung 3 ergibt sich:

$$OD \cdot V_{erase\,max} - 2EI \cdot V_{erase\,min} < \left| V_{write\,min} \right|$$

Damit sind für die Parameter c und d die folgenden Einschränkungen vorgegeben:

$$\frac{b}{2}(1 - \frac{V_{write\,min}}{OD \cdot V_{erase\,max}}) \leq c \leq b\frac{EI \cdot V_{erase\,min}}{OD \cdot V_{erase\,max}}$$

$$\frac{b}{2}(1 - \frac{V_{write\,min}}{OD \cdot V_{erase\,max}}) \leq d \leq b\frac{EI \cdot V_{erase\,min}}{OD \cdot V_{erase\,max}}$$

Bei Einhaltung dieser Bedingungen für die Parameter c und d ist gewährleistet, dass beim selektiven Löschen der Speicherzelle 5a die weiteren Speicherzellen 5c und 5d gegen unbeabsichtigtes Löschen geschützt und die weiteren Speicherzellen 5b, die weder an die ausgewählte erste Leitung 11a noch an die ausgewählte zweite Leitung 12a angeschlossen sind, gegen ein unbeabsichtigtes Programmieren geschützt sind. Insbesondere kann der Bereich, in dem die an die weiteren Speicherzellen angelegte Spannung U4 liegen darf, so gewählt werden, dass er nicht nur den Spannungsbereich zwischen -Verasemin und Verasemin umfasst, sondern zusätzlich noch den Spannungsbereich zwischen Vwritemin und -Verasemin. Dadurch wird der Asymmetrie des Schaltverhaltens festkörperelektrolytischer Speicherzellen Rechnung getragen, und die an den Speicherzellen 5c und 5d anliegenden Spannungen können noch kleiner gewählt werden, weil an den Speicherzellen 5b eine Spannung im Bereich zwischen Vwritemin und -Verasemin anliegen kann, ohne dass diese Speicherzellen versehentlich programmiert werden.

Zum Löschen der Speicherzelle 5a wird beispielsweise das erste Potential V1 der ausgewählten ersten Leitung 11a erhöht und das zweite Potential V2 der ausgewählten zweiten Leitung 11b abgesenkt. Damit diejenigen Speicherzellen 5c und 5d, die nur an eine der beiden Leitungen 11a, 12a angeschlossen sind, nicht ebenfalls gelöscht werden, werden auch die übrigen Leitungen 11b, 12b vorgespannt. Die Vorspannungen V3, V4 dieser übrigen Leitungen sind durch die Parameter c, d bestimmt, deren Größe durch die obigen Ungleichungen, die hier zusätzliche Randbedingungen darstellen, eingegrenzt ist. Wie bereits oben beschrieben, ist der Faktor OD größer oder gleich 1 und der Faktor EI kleiner oder gleich 1. Insbesondere ist zu erkennen, dass die Parameter c und d jeweils kleiner sind als b, woraus sich unmittelbar ergibt, dass an den Speicherzellen 5b, die nur an eine der ausgewählten Leitungen 11a, 12a, nicht aber an die jeweils andere ausgewählte Leitung 12a, 11a angeschlossen sind, mit einer Spannung U2 bzw. U3 vorgespannt werden, die kleiner ist als ΔV.

Mit den obigen Ungleichungen für die Höhe der Parameter c, d ist zugleich sichergestellt, dass die Spannungen U2, U3, mit denen diese Speicherzellen vorgespannt sind, kleiner oder gleich Verasemin sind. Ferner ist sichergestellt, dass der Betrag der vierten Spannung U4 kleiner ist als der Betrag von Vwritemin.

Indem die Potentiale V1, V2, V3 und V4 der ersten und zweiten Leitungen wie oben angegeben gewählt werden, lässt sich der integrierte Halbleiterspeicher erfindungsgemäß so betreiben, dass jede beliebige Speicherzelle 5a, die zum selektiven Löschen ausgewählt wird, selektiv zu allen übrigen Speicherzellen 5b, 5c, 5d gelöscht werden kann. Die Potentiale V1, V2, V3 und V4 werden vorzugsweise zur gleichen Zeit und während derselben Zeitdauer, d. h. in demselben Zeitintervall an die Leitungen 11a, 11b, 12a, 12b angelegt, damit zu jedem Zeitpunkt sichergestellt ist, dass ein unbeabsichtigtes Löschen oder Überschreiben einer der übrigen Speicherzellen 5b ausgeschlossen ist.

Mit Hilfe der vorliegenden Erfindung werden insbesondere festkörperelektrolytische Speicherzellen in der Weise einsetzbar sein, dass sie ebenso wie bei einem Direktzugriffsspeicher mit wahlweisem selektiven Zugriff auf jede beliebige individuelle Speicherzelle sowohl beim Schreiben als auch beim Löschen betreibbar sind.

Bezugszeichenliste

| 1 | Halbleiterspeicher |
| 2 | Anordnung |

| 5 | Speicherzelle |
|---|---|
| 5a | ausgewählte Speicherzelle |
| 5b, 5c, 5d | übrige Speicherzellen |
| 6 | Festkörperelektrolyt |
| 7 | metallische Schicht |
| 8 | Schichtenstapel |
| 11 | erste Leitung |
| 11a | ausgewählte erste Leitung |
| 11b | übrige erste Leitungen |
| 12 | zweite Leitung |
| 12a | ausgewählte zweite Leitung |
| 12b | übrige zweite Leitungen |
| a, b, c, d | Parameter |
| E1, E2 | Schwellwerte |
| EI | Parameter |
| I | Strom |
| $\Delta V$ | Löschspannung |
| OD | Parameter |
| U | Spannung |
| U1 | erste Spannung |
| U2 | zweite Spannung |
| U3 | dritte Spannung |
| U4 | vierte Spannung |
| $\Omega$ | ohmscher Widerstand |
| V1 | erstes Potential |
| V2 | zweites Potential |
| V3 | drittes Potential |
| V4 | viertes Potential |

| Verasemax | Grenzwert für eine Löschspannung, oberhalb dessen eine beliebige Speicherzelle zuverlässig gelöscht wird |
|---|---|
| Verasemin | Grenzwert für eine positive Spannung, unterhalb dessen ein Löschvorgang zuverlässig verhindert wird |
| Vwritemax | Grenzwert für eine Programmierspannung, unterhalb dessen eine beliebige Speicherzelle zuverlässig programmiert wird |
| Vwritemin | Grenzwert für eine negative Spannung, oberhalb dessen ein Programmiervorgang zuverlässig verhindert wird |
| VPL | Referenzpotential |

**Patentansprüche**

1. Integrierter Halbleiterspeicher (1) mit einer Anordnung (2) nichtflüchtiger Speicherzellen (5),

- wobei die Anordnung (2) eine Vielzahl von ersten Leitungen (11) und zweiten Leitungen (12) aufweist, die zum Programmieren und Löschen von Speicherzellen (5) elektrisch vorspannbar sind,
- wobei jede Speicherzelle (5) an eine erste Leitung (11) und eine zweite Leitung (12) angeschlossen ist und einen Schichtenstapel (8) aufweist, der einen Festkörperelektrolyten (6) aufweist und der zwischen der jeweiligen ersten Leitung (11) und der jeweiligen zweiten Leitung (12) angeordnet ist, an die die Speicherzelle (5) angeschlossen ist,
- wobei die Schichtenstapel (8) der Speicherzellen (5) so ausgebildet sind, dass ihr ohmscher Widerstand ($\Omega$) durch die Höhe einer zwischen der jeweiligen ersten Leitung (11) und der jeweiligen zweiten Leitung (12) anliegenden Spannung (U) veränderbar ist und bei ausreichend hoher positiver Spannung einen ersten Wert (R1) und bei ausreichend hoher negativer Spannung einen anderen, zweiten Wert (R2) annimmt,
- wobei die ersten Leitungen (11) und die zweiten Leitungen (12) so ansteuerbar sind, dass zum selektiven Löschen einer ausgewählten Speicherzelle (5a) selektiv zu allen übrigen Speicherzellen (5b, 5c, 5d) der Anordnung (2) von Speicherzellen elektrische Potentiale der ersten Leitungen (11) und der zweiten Leitungen (12) in der Weise geändert werden, dass jeweils diejenige erste Leitung (11a), an die die ausgewählte Speicherzelle (5a) angeschlossen ist, selektiv zu allen anderen ersten Leitungen (11b) mit einem ersten Potential (V1) und diejenige zweite Leitung (12a), an die die ausgewählte Speicherzelle (5a) angeschlossen ist, selektiv zu allen anderen zweiten Leitungen (12b) mit einem zweiten Potential (V2) vorgespannt wird und alle anderen ersten Leitungen (11b) mit einem dritten Potential (V3) und alle anderen zweiten Leitungen (12b) mit einem vierten Potential (V4) vorgespannt werden,

- wobei die Potentialdifferenz zwischen dem ersten Potential (V1) und dem zweiten Potential (V2) größer ist als ein Grenzwert (Verasemax) für eine Löschspannung, oberhalb dessen eine beliebige Speicherzelle (5) der Anordnung (2) zuverlässig gelöscht wird, und

- wobei das dritte (V3) und das vierte Potential (V4) so bemessen sind, dass während des selektiven Löschens der ausgewählten Speicherzelle (5a) an den anderen Speicherzellen (5b) anliegende Spannungen so gering sind, dass Löschvorgänge und Programmiervorgänge in den anderen Speicherzellen (5b, 5c, 5d) verhindert werden.

2.  Integrierter Halbleiterspeicher nach Anspruch 1,
    **dadurch gekennzeichnet, dass**
    die Schichtenstapel (8) der Speicherzellen (5) dann, wenn ihr ohmscher Widerstand ($\Omega$) den ersten Wert (R1) annimmt, hochohmig sind und dann, wenn ihr ohmscher Widerstand ($\Omega$) den zweiten Wert (R2) annimmt, niederohmig sind.

3.  Halbleiterspeicher nach Anspruch 1 oder 2,
    **dadurch gekennzeichnet, dass**
    der Halbleiterspeicher die Grösse des ohmschen Widerstandes ($\Omega$) der Schichtenstapel (8) so auswertet, dass hochohmige Speicherzellen als gelöschte Speicherzellen und niederohmige Speicherzellen als programmierte Speicherzellen erfasst werden.

4.  Halbleiterspeicher nach einem der Ansprüche 1 bis 3,
    **dadurch gekennzeichnet, dass**
    das erste (V1), das zweite (V2), das dritte (V3) und das vierte Potential (V4) gemäß den Bedingungen

$$V1 = VPL + \frac{a}{b} OD \cdot V_{erase\,max}$$

$$V2 = VPL + \frac{a-b}{b} OD \cdot V_{erase\,max}$$

$$V3 = VPL + \frac{d+a-b}{b} OD \cdot V_{erase\,max}$$

$$V4 = VPL + \frac{a-c}{b} OD \cdot V_{erase\,max}$$

und

$$\frac{b}{2}\left(1 - \frac{V_{write\,min}}{OD \cdot V_{erase\,max}}\right) \leq c \leq b\frac{EI \cdot V_{erase\,min}}{OD \cdot V_{erase\,max}}$$

$$\frac{b}{2}\left(1 - \frac{V_{write\,min}}{OD \cdot V_{erase\,max}}\right) \leq d \leq b\frac{EI \cdot V_{erase\,min}}{OD \cdot V_{erase\,max}}$$

vorgegeben sind,

- wobei VBL eine beliebige Referenzspannung, Verasemin ein Grenzwert für eine positive Spannung ist, unterhalb dessen ein Löschvorgang zuverlässig verhindert wird, und Vwritemin ein Grenzwert für eine negative Spannung ist, oberhalb dessen ein Programmiervorgang zuverlässig verhindert wird,
- wobei OD eine reelle Zahl, die mindestens = 1 beträgt, und EI eine reelle Zahl, die höchstens = 1 beträgt, ist.

5. Halbleiterspeicher nach Anspruch 4,
**dadurch gekennzeichnet, dass**
die Parameter a, b, c und d beliebige reelle Zahlen sind.

6. Halbleiterspeicher nach Anspruch 4,
**dadurch gekennzeichnet, dass**
die Parameter a, b, c und d jeweils ganze Zahlen sind.

7. Halbleiterspeicher nach Anspruch 4,
**dadurch gekennzeichnet, dass**
die Parameter a, b, c und d jeweils natürliche Zahlen sind.

8. Halbleiterspeicher nach einem der Ansprüche 4 bis 7,
**dadurch gekennzeichnet, dass**
der Parameter a = 0 ist.

9. Halbleiterspeicher nach einem der Ansprüche 4 bis 8,
**dadurch gekennzeichnet, dass**
die Parameter c und d gleich groß gewählt sind.

10. Halbleiterspeicher nach einem der Ansprüche 4 bis 9,
**dadurch gekennzeichnet, dass**
der Halbleiterspeicher so ausgebildet ist, dass alle ersten Leitungen (11) und alle zweiten Leitungen (12) dann, wenn der Speicherzustand aller Speicherzellen (5) unverändert aufrechterhalten wird, mit dem Referenzpotential (VPL) vorgespannt sind.

11. Halbleiterspeicher nach einem der Ansprüche 4 bis 10,
**dadurch gekennzeichnet, dass**
die Parameter b, c und d so gewählt sind, dass an denjenigen Speicherzellen (5b), die weder an die mit dem ersten Potential (V1) vorgespannte erste Leitung (11a) noch an die mit dem zweiten Potential (V2) vorgespannte zweite Leitung (12a) angeschlossen sind, eine negative Spannung (U4) anliegt.

**12.** Halbleiterspeicher nach einem der Ansprüche 1 bis 11,
**dadurch gekennzeichnet, dass**
die Parameter b, c und d so gewählt sind, dass der Betrag der Spannung (U4), die an denjenigen Speicherzellen (5b) anliegt, die weder an die mit dem ersten Potential (V1) vorgespannte erste Leitung (11a) noch an die mit dem zweiten Potential (V2) vorgespannte zweite Leitung (12a) angeschlossen sind, größer ist als der Grenzwert (Verasemin) für eine positive Spannung, unterhalb dessen ein Löschvorgang zuverlässig verhindert wird, und kleiner ist als der Betrag des Grenzwerts (Vwritemin) für eine negative Spannung, oberhalb dessen ein Programmiervorgang zuverlässig verhindert sind.

**13.** Halbleiterspeicher nach einem der Ansprüche 4 bis 12,
**dadurch gekennzeichnet, dass**
die Parameter b, c und d so gewählt sind, dass beim Löschen der ausgewählten Speicherzelle (5a) die Größe der an den anderen Speicherzellen (5b, 5c, 5d) anliegenden Spannungen (U2, U3, U4) kleiner ist als der Grenzwert (Verasemin) für eine positive Spannung, unterhalb dessen ein Löschvorgang zuverlässig verhindert wird, aber größer ist als der Grenzwert (Vwritemin) für eine negative Spannung, oberhalb dessen ein Programmiervorgang zuverlässig verhindert wird.

**14.** Halbleiterspeicher nach einem der Ansprüche 1 bis 13,
**dadurch gekennzeichnet, dass**
die Schichtenstapel (8) der Speicherzellen (5) auf einer Seite des Festkörperelektrolyten (6) jeweils eine metallhaltige Schicht (7) aufweisen, aus der dann, wenn an dem jeweiligen Schichtenstapel (8) eine ausreichend hohe Schreibspannung anliegt, Metallionen (9) in den Festkörperelektrolyten (6) hineindiffundieren.

**15.** Halbleiterspeicher nach Anspruch 14,
**dadurch gekennzeichnet, dass**
die Materialzusammensetzung des Festkörperelektrolyten (6) und der metallhaltigen Schicht (7) so beschaffen ist, dass Schwellwerte (G1) für Löschspannungen, bei denen niederohmige Speicherzellen hochohmig werden, und Schwellwerte (G2) für Programmierspannungen, bei denen hochohmige Speicherzellen niederohmig werden, für die Vielzahl von Speicherzellen (5) statistisch über Spannungsbereiche verteilt sind, wobei die Schwellwerte (G1) für Löschspannungen über einen größeren Spannungsbereich verteilt sind als die Schwellwerte (G2) für Programmierspannungen.

**16.** Halbleiterspeicher nach Anspruch 15,
**dadurch gekennzeichnet, dass**
die Materialzusammensetzung des Festkörperelektrolyten (6) und der metallhaltigen Schicht (7) so beschaffen ist, dass der Grenzwert (Verasemin) für eine positive Spannung, unterhalb dessen ein Löschvorgang zuverlässig verhindert wird, kleiner ist als der Betrag des Grenzwertes (Vwritemin) für eine negative Spannung, oberhalb dessen ein Programmiervorgang zuverlässig verhindert wird.

**17.** Halbleiterspeicher nach einem der Ansprüche 14 bis 16,
**dadurch gekennzeichnet, dass**
die Spannungsabhängigkeit des ohmschen Widerstandes ($\Omega$) der Schichtenstapel (8) so beschaffen ist, dass der Grenzwert (Verasemax) für eine Löschspannung, oberhalb derer eine beliebige Speicherzelle zuverlässig gelöscht wird, größer ist als der Betrag des Grenzwertes (Vwritemax) für eine Programmierspannung, unterhalb dessen eine beliebige Speicherzelle zuverlässig programmiert wird.

**18.** Halbleiterspeicher nach einem der Ansprüche 1 bis 17,
**dadurch gekennzeichnet, dass**
der Festkörperelektrolyt (6) der Schichtenstapel (8) ein glasförmiges Material enthält.

**19.** Halbleiterspeicher nach einem der Ansprüche 1 bis 18,
**dadurch gekennzeichnet, dass**
der Festkörperelektrolyt (6) der Schichtenstapel (8) ein Chalcogenid enthält.

**20.** Halbleiterspeicher nach einem der Ansprüche 1 bis 19,
**dadurch gekennzeichnet, dass**
die ersten Leitungen (11) und die zweiten Leitungen (12) auf zueinander entgegengesetzten Seiten der Schichtenstapel (8) angeordnet sind.

21. Verfahren zum Betreiben eines integrierten Halbleiterspeichers (1) nach einem der Ansprüche 1 bis 20, wobei eine ausgewählte Speicherzelle (5a) eine Anordnung (2) von Speicherzellen (5) selektiv zu allen übrigen Speicherzellen (5b, 5c, 5d) der Anordnung (2) gelöscht wird, indem die folgenden Schritte durchgeführt werden:

    a) Vorspannen derjenigen ersten Leitung (11a), an die die ausgewählte Speicherzelle (5a) angeschlossen ist, mit dem ersten Potential (V1),
    b) Vorspannen derjenigen zweiten Leitung (12a), an die die ausgewählte Speicherzelle (5a) angeschlossen ist, mit dem zweiten Potential (V2),
    c) Vorspannen der übrigen ersten Leitung (11b) mit dem dritten Potential (V3) und
    d) Vorspannen der übrigen zweiten Leitung (12b) mit dem vierten Potential (V4).

22. Verfahren nach Anspruch 21,
**dadurch gekennzeichnet, dass**
das die Höhe des ersten (V1), des zweiten (V2), des dritten (V3) und des vierten Potentials (V4) gemäss einem der Ansprüche 4 bis 9 oder 11 bis 13 festgelegt wird.

23. Verfahren nach Anspruch 22,
**dadurch gekennzeichnet, dass**
die Höhe des ersten (V1), zweiten (V2), dritten (V3) und vierten Potentials (V4) jeweils von der Höhe einer Referenzspannung (VPL) verschieden ist.

24. Verfahren nach Anspruch 23,
**dadurch gekennzeichnet, dass**
die Höhe des ersten (V1), zweiten (V2), dritten (V3) und vierten Potentials (V4) jeweils verschieden ist von der Höhe einer solchen Referenzspannung (VPL), mit der die ersten Leitungen (11) und zweiten Leitungen (12) vorgespannt sind, wenn keine der Speicherzellen gelöscht oder programmiert wird.

25. Verfahren nach einem der Ansprüche 22 bis 24,
**dadurch gekennzeichnet, dass**
zum Festlegen der Höhe des ersten (V1), zweiten (V2), dritten (V3) und vierten Potentials (V4) die Parameter a, b, c und d so gewählt werden, dass der Parameter a ungleich Null ist, die Parameter b und c jeweils von dem Parameter a verschieden sind und der Parameter d von der Differenz zwischen den Parametern b und a verschieden ist.

FIG 1

FIG 2

$$\Omega = \Omega(V1-V2)$$

# FIG 3

# FIG 4

# FIG 5

1; 2

12; 12b    12; 12a    12; 12b

V3 = VPL + (d+a-b)/b·ΔV

11; 11b

5; 5b -(b-(c+d))·ΔV/b = U4

5; 5b -(b-(c+d))·ΔV/b

$\frac{d}{b}$·ΔV = U3  5; 5d

5; 5b -(b-(c+d))·ΔV/b

V1 = VPL + a/b·ΔV

11; 11a

5; 5c  $\frac{c}{b}$·ΔV = U2

5; 5c  $\frac{c}{b}$·ΔV

5; 5a  ΔV = U1

5; 5c  $\frac{c}{b}$·ΔV

V3 = VPL + (d+a-b)/b·ΔV

11; 11b

5; 5b -(b-(c+d))·ΔV/b

5; 5b -(b-(c+d))·ΔV/b

5; 5d  $\frac{d}{b}$·ΔV

5; 5b -(b-(c+d))·ΔV/b

V3 = VPL + (d+a-b)/b·ΔV

5; 5b -(b-(c+d))·ΔV/b

5; 5b -(b-(c+d))·ΔV/b

5; 5d  $\frac{d}{b}$·ΔV

5; 5b -(b-(c+d))·ΔV/b

V4 = VPL + (a-c)/b·ΔV

VPL + (a-c)/b·ΔV

V2 = VPL + (a-b)/b·ΔV

VPL + (a-c)/b·ΔV

U1 = V1 - V2
U2 = V1 - V4
U3 = V3 - V2
U4 = V3 - V4